# EUROPÄISCHE PATENTANMELDUNG

(11) **EP 2 760 133 A1**
(43) Veröffentlichungstag der Anmeldung: **30.07.2014**
(21) Anmeldenummer: 13005570.0
(22) Anmeldetag: 29.11.2013
(51) Int. Cl.: H03K 17/97, A45C 7/00

(54) **Energieautarkes Elektronik-Gerät**

(30) Priorität: 28.01.2013 DE 202013001367 U
(71) Anmelder: ABB AG, 68309 Mannheim (DE)
(72) Erfinder: Czimmeck, Frank, 58511 Lüdenscheid (DE)

(57) **Zusammenfassung**

Es wird ein energieautarkes Elektronik-Gerät (1) vorgeschlagen,
• mit einem Dreh-Bedienknopf (2), dessen Drehachse (3) mit einem wechselseitig am Innendurchmesser mehrpolig magnetisierten Polrad (12) gekoppelt ist, wobei jeweils zwischen zwei Magneten (13 - 20) des Polrades (12) ein Nichtmagnet-Abschnitt (21) ausgebildet ist,
• mit einem unter dem Dreh-Bedienknopf (2) befindlichen, aus mehreren Spulen (24, 25, 26, 27, 28, 29) aufgebauten Stator (22), wobei diese Spulen (24 - 29) fest gegenüber dem Polrad (12) auf einer Grundplatte (23) des Elektronik-Geräts (1) montiert und mit Anschlussleitungen (30) verbunden sind,
• wobei die an den Anschlussleitungen (30) während einer Drehbewegung des Dreh-Bedienknopf (2) mittels der Polrad/Stator-Konfiguration erzeugte elektrische Energie zur Speisung von Elektronik-Baukomponenten des Elektronik-Geräts (1) zur Verfügung steht,
• wobei ein Mikrocontroller (9) an die Anschlussleitungen (30) angeschlossen ist, der an Hand des zeitlichen Verlaufs der an den Anschlussleitungen (30) anstehenden Spannung erkennt, in welcher Position sich der Dreh-Bedienknopf (2) befindet.

## Beschreibung

Die Erfindung betrifft ein energieautarkes Elektronik-Gerät im Allgemeinen, wobei hierunter auch ein Elektro-Installationsgerät mit Drehknopffunktion in der Gebäudesystemtechnik (Drehbedienelement) im engeren Sinn und ein Dreh-Dimm-Regler im Speziellen subsummiert werden.

Aus der DE 103 05 873 A1 ist ein energieautarkes elektrisches Installationsgerät, insbesondere Schalter oder Taster, bekannt, mit einem eine elektromagnetische Induktionsspule enthaltenden elektro-akustischen Wandler, wobei der elektroakustische Wandler Druckänderungen in einem Gas in elektrische Energie umwandelt, welche mittels einer Gleichrichterschaltung gleichgerichtet wird und mittels eines Speichelements speicherbar ist. Als elektromagnetische Induktionsspule dient eine Tauchspule, welche über eine Tauchspulenbefestigung mit einer Membrane verbunden ist und in einen Permanentmagneten eintaucht, wobei die Tauchspule mit einer Primärwicklung eines Transformators verbunden ist, an dessen Sekundärwicklung die Gleichrichterschaltung angeschlossen ist.

Aus der DE 297 12 270 U1 ist ein Installationsschalter bekannt, der mit einem von Hand zu betätigenden Bedienkörper arbeitet, der mittels einer Wirkungskette zum Schalten eine Schalteinrichtung für Schaltkontakte betätigt, wobei in der Wirkungskette ein in verarbeitbare elektrische Signale umformender Wandler eines Sendeelements angeordnet ist. Es kann sich dabei um einen Wandler aus piezoelektrischem Material handeln. Bei einem Bedienkörper in der Ausführung als Wippe oder Taster kann der Wandler als Biegewandler oder Druckwandler ausgeführt sein.

Aus der DE 100 63 305 C1 ist ein elektronischer Schalter, insbesondere Lichtschalter bekannt, welcher einen piezokeramischen Biegestreifen aufweist, wobei dieser biegbare Träger als Tasterzunge ausgebildet sein kann, die das Bedienelement des Schalters bildet. Bei Betätigung des Schalters kann derart Spannung abgegriffen werden.

Der Erfindung liegt die Aufgabe zugrunde, ein optimiertes energieautarkes Elektronik-Gerät anzugeben.

Diese Aufgabe wird erfindungsgemäß gelöst durch ein energieautarkes Elektronik-Gerät
- mit einem Dreh-Bedienknopf, dessen Drehachse mit einem wechselseitig am Innendurchmesser mehrpolig magnetisierten Polrad gekoppelt ist, wobei jeweils zwischen zwei Magneten des Polrades ein Nichtmagnet-Abschnitt ausgebildet ist,
- mit einem unter dem Dreh-Bedienknopf befindlichen, aus mehreren Spulen aufgebauten Stator, wobei diese Spulen fest gegenüber dem Polrad auf einer Grundplatte des Elektronik-Geräts montiert und mit Anschlussleitungen verbunden sind,
- wobei die an den Anschlussleitungen während einer Drehbewegung des Dreh-Bedienknopf mittels der Polrad/Stator-Konfiguration erzeugte elektrische Energie zur Speisung von Elektronik-Baukomponenten des Elektronik-Geräts zur Verfügung steht,
- wobei ein Mikrocontroller an die Anschlussleitungen angeschlossen ist, der an Hand des zeitlichen Verlaufs der an den Anschlussleitungen anstehenden Spannung erkennt, in welcher Position sich der Dreh-Bedienknopf befindet.

Zweckmäßig kann als Elektronik-Baukomponenten des Elektronik-Geräts eine vom Mikrokontroller ansteuerbare Anzeigeeinheit zur Signalisierung und Visualisierung von Daten mit den Anschlussleitungen verbunden sein.

In weiterer Ausgestaltung kann als Elektronik-Baukomponenten des Elektronik-Geräts eine vom Mikrokontroller ansteuerbare Busanbindung vorgesehen sein, um derart kabelgebunden den Anschluss an ein Netzwerk / Bussystem herzustellen.

Des Weiteren kann als Elektronik-Baukomponenten des Elektronik-Geräts eine vom Mikrokontroller ansteuerbare Drahtlosanbindung vorgesehen sein, um derart über Funk den Anschluss an ein Netzwerk / Bussystem herzustellen.

Gemäß einer weiteren Ausbildung kann als Elektronik-Baukomponenten des Elektronik-Geräts ein vom Mikrokontroller ansteuerbarer Schaltausgang vorgesehen sein, um derart einen bistabilen Schaltausgang zu realisieren.

Zweckmäßig ist ein Energiespeicher für die Speicherung der mit der Polrad/Stator-Konfiguration erzeugten elektrischen Energie mit den Anschlussleitungen verbunden.

Die mit der Erfindung erzielbaren Vorteile liegen insbesondere darin, dass die Drehbewegung des Nutzers bei Betätigung des Dreh-Bedienknopfes von Hand und damit Bedienung des Elektronik-Geräts zusätzlich zur Vorgabe eines gewünschten Wertes auch zur Energiegewinnung herangezogen wird, um auf diese Weise Elektronik-Baukomponenten eines autarken Elektronik-Geräts im Allgemeinen, eines autarken Elektro-Installationsgeräts mit Drehknopffunktion in der Gebäudesystemtechnik (Drehbedienelement, z. B. Temperatursteller) im engeren Sinn und eines Dreh-Dimm-Reglers im Speziellen, jeweils ohne Netzanschluss, ohne Solarzellen und ohne Batterien oder Akkumulatoren betreiben zu können.

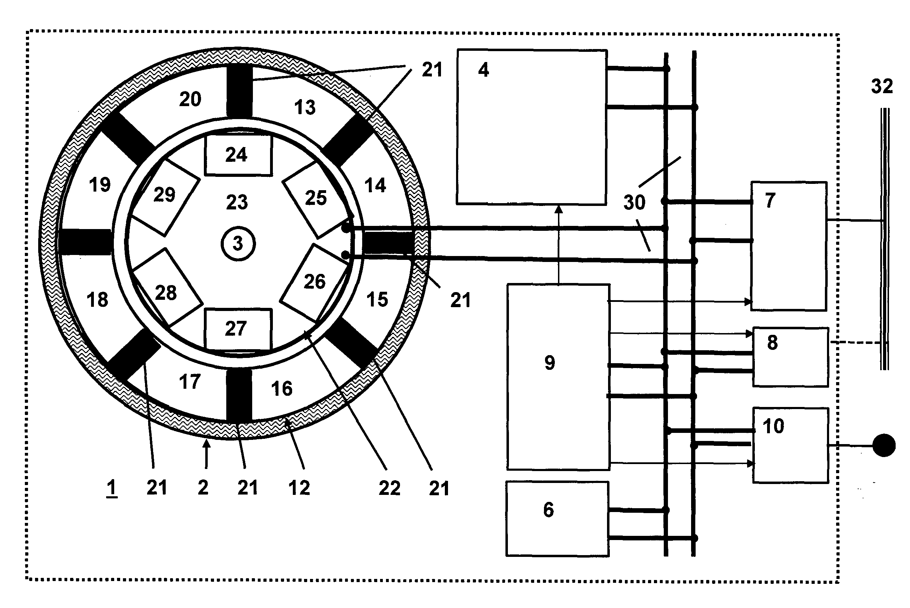

Die Erfindung wird nachstehend an Hand des in der Zeichnung dargestellten Ausführungsbeispiels erläutert.

In der einzigen Figur ist ein Elektronik-Gerät 1, insbesondere ein Dreh-Dimm-Regler zur Einstellung der Helligkeit einer Beleuchtung oder ein Temperatursteller, d. h. Temperatur-Sollwertgeber zur Einstellung der Raumtemperatur, dargestellt,
- welches kabelgebunden an ein Netzwerk / Bussystem 32 angeschlossen ist, um derart über das Netzwerk / Bussystem 32 und einen Aktor ein elektrisches Gerät anzusteuern und/oder
- welches drahtlos an ein Netzwerk / Bussystem 32 angeschlossen ist, um derart über das Netzwerk / Bussystem 32 und einen Aktor ein elektrisches Gerät anzusteuern und/oder
- welches einen Schaltausgang 10 für die Ansteuerung eines elektrischen Geräts über einen Aktor aufweist.

Das Elektronik-Gerät 1 weist einen von einem Nutzer um eine Drehachse 3 drehbaren Dreh-Bedienknopf 2 auf, welcher eine von einem Nutzer von Hand ausgeführte mechanische Drehbewegung in ein elektrisches Signal wandelt, wodurch das Elektronik-Gerät 1 z. B. als Drehgeber zur Vorgabe eines gewünschten Dimmwertes einer Beleuchtung oder zur Vorgabe einer gewünschten Raumtemperatur dient.

Ein wesentliches Merkmal des vorgeschlagenen Elektronik-Geräts ist die durch die ausgeführte mechanische Drehbewegung des Dreh-Bedienknopfes 2 bewirkte Energieumwandlung von mechanischer Energie in elektrische Energie. Für diese Energieumwandlung weist das Elektronik-Gerät 1 folgende Baukomponenten auf:
- ein wechselseitig am Innendurchmesser mehrpolig magnetisiertes und mit dem Dreh-Bedienknopf 2 direkt gekoppeltes Polrad 12, welches beispielsweise aus acht Magneten 13, 14, 15, 16, 17, 18, 19, 20 gebildet ist, wobei jeweils zwischen zwei Magneten 13 - 20 ein Nichtmagnet-Abschnitt 21 ausgebildet ist,
- einen unter dem Dreh-Bedienknopf 2 befindlichen, aus mehreren, beispielsweise aus sechs Spulen 24, 25, 26, 27, 28, 29 aufgebauten (innenliegenden) Stator 22, wobei diese Spulen 24 - 29 fest gegenüber dem Polrad 12 auf einer Grundplatte 23 des Stators 22 respektive des Elektronik-Geräts 1 montiert sind.
   Für den elektrischen Anschluss sind die Spulen 24 - 29 beispielsweise separat mit den Anschlussleitungen 30 geschaltet. Mit diesen Anschlussleitungen 30 ist ein Mikrocontroller 9 verbunden, welcher als Steuerlogik / Auswertungseinheit / Verarbeitungseinheit dient. Vorzugsweise wird jede einzelne Spule vom Mikrocontroller 9 überwacht. Durch das Weglassen einiger Magnete bzw. das Nichtmagnetisieren einiger Stellen des mit dem Dreh-Bedienknopf 2 verbundenen Polrades 12 kann der Mikrocontroller 9 an Hand des zeitlichen Verlaufs der an den Anschlussleitungen 30 anstehenden Spannung genau erkennen, in welcher Position sich der Dreh-Bedienknopf 2 beim Drehen befindet. Somit ist eine Auswertung möglich,
- ob der Dreh-Bedienknopf 2 links oder rechts herum gedreht wird,
- um welchen Winkel der Dreh-Bedienknopf 2 gedreht wird.

Das entsprechend dieser Auswertung gewonnene elektrische Auswerte-Signal kann für Elektronik-Baukomponenten des Elektronik-Geräts 1 herangezogen werden, um z. B. folgende Aktionen durchzuführen:
- Aussendung eines dem Auswerte-Signal entsprechenden Funktelegramms und/oder
- Speisung einer Anzeigeeinheit mit einer dem Auswerte-Signal entsprechenden Information, z. B. eines E-Ink-Displays und/oder
- Setzen eines bistabilen Schaltausgangs entsprechend dem Auswerte-Signal.

Die zur Aussendung eines entsprechenden Funktelegramms und/oder Speisung einer Anzeigeeinheit (eines E-Ink-Displays) und/oder Setzen eines bistabilen Schaltausgangs erforderliche elektrische Energie wird durch die vorstehend erläuterte Polrad/Stator-Konfiguration bei Betätigung des Dreh-Bedienknopfes von Hand gewonnen, wobei die Polrad/Stator-Konfiguration der miniaturisierten Version einer Drehstromlichtmaschine (Drehstromgenerator) entspricht, wie sie beispielsweise bei Motorrädern verwendet wird.

Optional kann das Elektronik-Gerät 1 als eine von der Polrad/Stator-Konfiguration einspeisbare Elektronik-Baukomponente eine mit den Anschlussleitungen 30 verbundene Anzeigeeinheit 4 zur Signalisierung und Visualisierung von Daten, wie insbesondere Text und/oder Grafik aufweisen, wie vorstehend angedeutet.

Optional kann das Elektronik-Gerät 1 als eine von der Polrad/Stator-Konfiguration einspeisbare Elektronik-Baukomponente eine Busanbindung (Buskoppler) 7 aufweisen, um derart kabelgebunden den Anschluss an das Netzwerk / Bussystem 32 herzustellen, wie vorstehend angedeutet.

Optional kann das Elektronik-Gerät 1 als eine von der Polrad/Stator-Konfiguration einspeisbare Elektronik-Baukomponente eine Drahtlosanbindung 8 aufweisen, um derart über Funk den Anschluss an das Netzwerk / Bussystem 32 herzustellen, wie vorstehend angedeutet. Dementsprechend weist die Drahtlosanbindung 8 einen Funksender auf.

Optional kann das Elektronik-Gerät 1 als eine von der Polrad/Stator-Konfiguration einspeisbare Elektronik-Baukomponente einen Schaltausgang 10 aufweisen, um derart den bistabilen Schaltausgang zu realisieren, wie vorstehend angedeutet.

Für die Speicherung der mit der Polrad/Stator-Konfiguration erzeugten elektrischen Energie kann optional ein Energiespeicher 6 mit den Anschlussleitungen 30 verbunden sein.

### Bezugszeichenliste

- 1: Elektronik-Gerät (z. B. Dreh-Dimm-Regler, Temperatursteller)
- 2: Dreh-Bedienknopf (Drehgeber, mechanische Drehbewegung)
- 3: Drehachse
- 4: Anzeigeeinheit (zur Signalisierung und Visualisierung von Daten, wie Text oder Grafik)
- 5: -
- 6: Energiespeicher
- 7: Busanbindung
- 8: Drahtlosanbindung
- 9: Mikrocontroller: Steuerlogik / Auswertungseinheit / Verarbeitungseinheit
- 10: Schaltausgang
- 11: -
- 12: Mehrpolig magnetisiertes Polrad
- 13: Magnet
- 14: Magnet
- 15: Magnet
- 16: Magnet
- 17: Magnet
- 18: Magnet
- 19: Magnet
- 20: Magnet
- 21: Nichtmagnet-Abschnitt
- 22: Stator
- 23: Grundplatte
- 24: Spule eines Stators
- 25: Spule eines Stators
- 26: Spule eines Stators
- 27: Spule eines Stators
- 28: Spule eines Stators
- 29: Spule eines Stators
- 30: Anschlussleitungen
- 31: -
- 32: Netzwerk / Bussystem

## Patentansprüche

1. Energieautarkes Elektronik-Gerät (1)
• mit einem Dreh-Bedienknopf (2), dessen Drehachse (3) mit einem wechselseitig am Innendurchmesser mehrpolig magnetisierten Polrad (12) gekoppelt ist, wobei jeweils zwischen zwei Magneten (13 - 20) des Polrades (12) ein Nichtmagnet-Abschnitt (21) ausgebildet ist,
• mit einem unter dem Dreh-Bedienknopf (2) befindlichen, aus mehreren Spulen (24, 25, 26, 27, 28, 29) aufgebauten Stator (22), wobei diese Spulen (24 - 29) fest gegenüber dem Polrad (12) auf einer Grundplatte (23) des Elektronik-Geräts (1) montiert und mit Anschlussleitungen (30) verbunden sind,
• wobei die an den Anschlussleitungen (30) während einer Drehbewegung des Dreh-Bedienknopf (2) mittels der Polrad/Stator-Konfiguration erzeugte elektrische Energie zur Speisung von Elektronik-Baukomponenten des Elektronik-Geräts (1) zur Verfügung steht,
• wobei ein Mikrocontroller (9) an die Anschlussleitungen (30) angeschlossen ist, der an Hand des zeitlichen Verlaufs der an den Anschlussleitungen (30) anstehenden Spannung erkennt, in welcher Position sich der Dreh-Bedienknopf (2) befindet.

2. Energieautarkes Elektronik-Gerät (1) nach Anspruch 1, **dadurch gekennzeichnet, dass** eine vom Mikrokontroller (9) ansteuerbare Anzeigeeinheit (4) zur Signalisierung und Visualisierung von Daten mit den Anschlussleitungen (30) verbundenen ist.

3. Energieautarkes Elektronik-Gerät (1) nach Anspruch 1, **dadurch gekennzeichnet, dass** eine vom Mikrokontroller (9) ansteuerbare Busanbindung (7) vorgesehen ist, um derart kabelgebunden den Anschluss an ein Netzwerk / Bussystem (32) herzustellen.

4. Energieautarkes Elektronik-Gerät (1) nach Anspruch 1, **dadurch gekennzeichnet, dass** eine vom Mikrokontroller (9) ansteuerbare Drahtlosanbindung (8) vorgesehen ist, um derart über Funk den Anschluss an ein Netzwerk / Bussystem (32) herzustellen.

5. Energieautarkes Elektronik-Gerät (1) nach Anspruch 1, **dadurch gekennzeichnet, dass** ein vom Mikrokontroller (9) ansteuerbarer Schaltausgang (10) vorgesehen ist, um derart einen bistabilen Schaltausgang zu realisieren.

6. Energieautarkes Elektronik-Gerät (1) nach Anspruch 1, **dadurch gekennzeichnet, dass** ein Energiespeicher (6) für die Speicherung der mit der Polrad/Stator-Konfiguration erzeugten elektrischen Energie mit den Anschlussleitungen 30 verbunden ist.
